Europäisches Patentamt

European Patent Office

Office européen des brevets

(19)

(11) Publication number : **0 499 418 A2**

(12) **EUROPEAN PATENT APPLICATION**

(21) Application number : 92301053.2

(22) Date of filing : 07.02.92

(51) Int. Cl.⁵ : **G06F 15/16**

(30) Priority : **13.02.91 GB 9103037**

(43) Date of publication of application :
**19.08.92 Bulletin 92/34**

(84) Designated Contracting States :
**BE DE DK ES FR GR IT LU NL PT SE**

(71) Applicant : **GPT LIMITED**
**New Century Park P.O. Box 53**
**Coventry, CV3 1HJ (GB)**

(72) Inventor : **Bird, John Robert**
**21 Cambridge House, Courtfield Gardens**
**Ealing, London W13 0HP (GB)**
Inventor : **Mulley, Christopher Brian**
**5 Kennet Close**
**West End, Southampton SO3 3JY (GB)**
Inventor : **Wei, Li**
**22 Priory Gardens, Sudbury**
**Wembley, Middlesex HA0 2QG (GB)**

(74) Representative : **Branfield, Henry Anthony**
**The General Electric Company plc Patent**
**Department(Wembley Office) Hirst Research**
**Centre East Lane**
**Wembley, Middlesex HA9 7PP (GB)**

(54) **A user configurable logic device method and arrangement.**

(57)    A User Configurable Logic Device is a digital integrated circuit whose function may be tailed or adapted by the user.
    A method of configuring an arrangement of user configurable logic devices including a lead device and one or more slave devices and a PROM comprising the step of loading into the lead device a configuration from the PROM including an external interface to the lead device.

Fig.3

A User Configurable Logic Device is a digital integrated circuit whose function may be tailored or adapted by the user. The tailoring does not form part of the device manufacturing process. In User Configurable Logic Devices a specific function is assigned to a device by means of a process referred to as configuration. Configuration involves the transfer of digital data from some form of storage into the device. The configuration data defines the logic function of some or all of the logic elements present in the device, and also defines how the logic elements are connected to one another and to the external connections of the device. After configuration, the configuration data is held in storage elements within the device. The use of volatile storage elements results in the device losing its defined function whenever the power supply is removed. It therefore follows that configuration must be performed whenever the power supply to the device is restored.

According to the present invention there is provided a method of configuring an arrangement of user configurable logic devices including a lead device and one or more slave devices and a PROM comprising the step of loading into the lead device a configuration from the PROM said configuration including an external interface to the lead device.

There is further provided a method as above including the step of down-loading an alternative configuration to the slave devices by way of the interface.

Also there is provided an arrangement of user configurable logic devices including a lead device and one or more slave devices, and a PROM, wherein the PROM is programmed to configure the arrangement to provide an external interface to the lead device.

Reference will now be made to arrangements using a particular form of User Configurable Logic Device known as a Logic Cell Array (LCA) and the present invention will now be described, by way of example, with reference to the accompanying drawings, in which :

Figure 1 is a diagram showing the process of configuring a single Logic Cell Array according to the prior art;

Figure 2 is a diagram showing the process of configuring multiple Logic Cell Arrays according to the prior art;

Figure 3 is a diagram showing the process of configuring multiple Logic Cell Arrays according to the present invention.

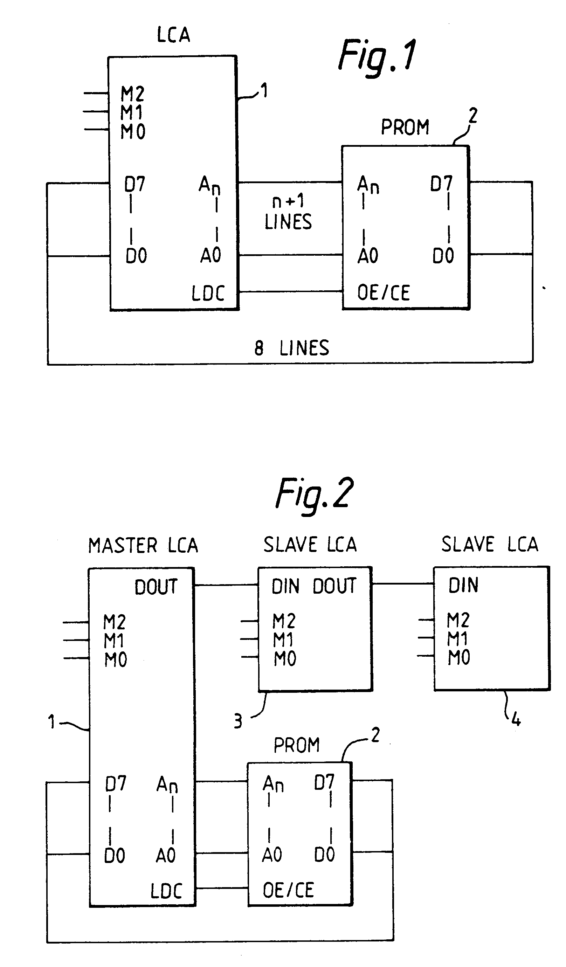

One prior art method of configuring a single LCA is shown in Figure 1.

On power-up, the LCA 1 automatically enables the configuration PROM 2 by applying a signal from LDC to OE/CE, and generates the required sequence of addresses on AO to $A_n$. The configuration data is read into the LCA 1 on lines D7 to D0. When configuration is complete, the "user" i/o lines of the LCA 1 (not shown) assume their programmed functions. Many of the LCA 1 i/o lines concerned with configuration may also have a "user" function which becomes operational when configuration is complete. The lines M2, M1 and M0 are used to select between a number of configuration modes, such as "master" as described here and "slave", to be described below. A full description of LCA configuration modes may be found in the XILINX (Trade Mark) Programmable Gate Array Data Book, 1989 edition, pps 2.14 et seq.

A number of LCAs may be configured from configuration data stored in a single PROM, by means of a daisy chain arrangement as shown in Figure 2.

The LCA 1 to which the PROM 2 is attached is designated as the master, and is the first to be configured. Further configuration data from the PROM 2 is then passed serially from the master LCA 1 DOUT pin to the first of a number of slave LCAs 3, 4 connected in a daisy chain. The process continues until the last slave LCA 4 in the chain has been configured. This arrangement is described fully in the aforementioned XILINX Data Book pps 2.20 and 2.21, and illustrated in Figure 23 thereof.

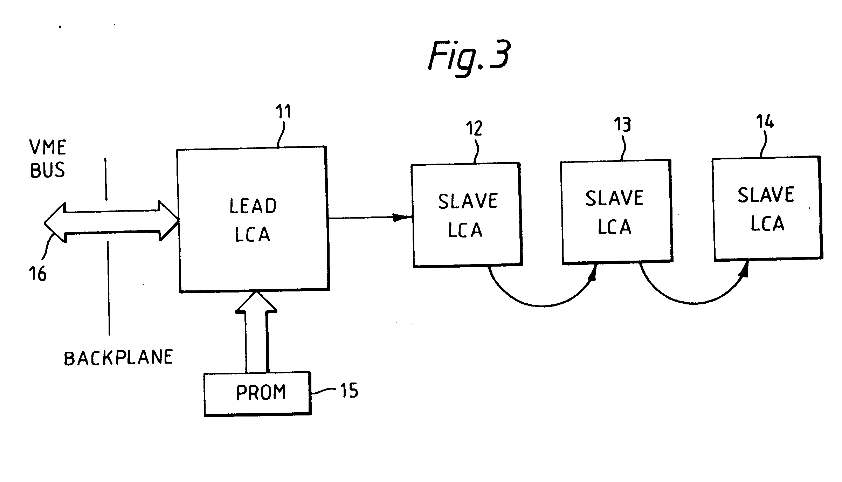

The LCA configuration method of the present invention is illustrated in Figure 3. This is a variant of the daisy chain arrangement described above. Once again the configuration data for all of the LCAs 11, 12, 13, 14, is held in a single PROM 15. The "lead" LCA 11 shown in Figure 3 performs the same function during configuration as the "master" LCA 1 in Figure 2.

One of the functions loaded into the lead LCA 11 during configuration is a VME bus interface 16. Control information from a personal computer (PC) (not shown) may be used as a means of down-loading alternative configuration data via the VME bus interface 16 to the slave LCAs 12, 13, 14. Additionally, the control information from the PC may be routed by the LCAs, 11, 12, 13, 14 to switch hardware (not shown). The re-configuration method works as follows:-

The PC instructs the lead LCA 11 via the VME bus 16 to provide a reset signal to all of the slave LCAs 12, 13,14. This causes the slave LCAs 12, 13,14 to behave as if they had just been powered up.

The PC then starts to down-load configuration data for the slave LCAs 12, 13, 14.

The lead LCA 11 passes this data to the slave LCAs 12, 13, 14 using exactly the same daisy chain arrangement as for the initial power-up configuration. In doing this, the lead LCA 11 is effectively emulating its own actions carried out previously during power-up configuration, except that:

The configuration data for the slave LCAs 12, 13, 14 comes from the VME bus 16 rather than the PROM 15.

The lead LCA 11 is not itself re-configured since it houses the VME interface function used in the reconfiguration process.

The hardware within the LCA 11 which performs emulation of the power-up configuration process is part of the overall function initially loaded into the lead LCA 11 from the PROM 15 during power-up configuration.

The method is not generally confined to reconfiguration. It would be equally possible to configure only the lead LCA 11 from the PROM 15 on power-up. The initial configuration data (and the data for any subsequent reconfigurations) for the slave LCAs 12, 13, 14 would then be transferred to the slave LCAs 12, 13, 14 via the VME bus 16.

Further variations are as follows:-

Reconfigured slave LCAs 12, 13, 14 can be returned to their original (power-up) configuration by instructing the lead LCA 11 to reset the slaves and then to configure them from data stored in the PROM 15.

A "down-load cable" can be used in place of the VME bus. This provides a serial communications link between the PC and the lead LCA 11.

## Claims

1. A method of configuring an arrangement of user configurable logic devices including a lead device and one or more slave devices and a PROM comprising the step of loading into the lead device a configuration from the PROM said configuration including an external interface to the lead device.

2. A method as claimed in Claim 1 further including the step of down-loading an alternative configuration to the slave devices by way of the interface under the control of the lead device.

3. A method as claimed in Claim 2 wherein the slave devices are configured by a personal computer connected to the interface.

4. A method as claimed in Claim 2 or 3 wherein the interface is a VME interface.

5. A method as claimed in any preceding claim further including the step of communicating control information from a personal computer to the devices by way of the interface.

6. A method as claimed in Claim 5 when appendant to Claim 3 wherein the lead device provides a reset signal to the slave devices in response to a signal from the personal computer.

7. A method as claimed in Claim 2 or any Claim appendant thereto further including the step of resetting the slave devices under control from the interface and configuring them from information stored in the PROM.

8. An arrangement of user configurable logic devices including a lead device and one or more slave devices, and a PROM, wherein the PROM is programmed to configure the arrangement to provide an external interface to the lead device.

*Fig.1*

*Fig.2*

4

## Fig.3

VME
BUS

BACKPLANE

LEAD
LCA  11

SLAVE
LCA  12

SLAVE
LCA  13

SLAVE
LCA  14

16

PROM  15